# EUROPÄISCHE PATENTANMELDUNG

(11) **EP 2 320 568 A2**
(43) Veröffentlichungstag der Anmeldung: **11.05.2011**
(21) Anmeldenummer: 10013607.6
(22) Anmeldetag: 13.10.2010
(51) Int. Cl.: H03K 17/96

(54) **Bedienvorrichtung eines elektronischen Haushaltsgeräts**

(30) Priorität: 28.10.2009 DE 102009050958
(71) Anmelder: Diehl AKO Stiftung & Co. KG, 88239 Wangen (DE)
(72) Erfinder: Kaps, Werner, 88171 Weiler-Simmerberg (DE); Frommelt, Thomas, 81243 München (DE)
(74) Vertreter: Diehl Patentabteilung

(57) **Zusammenfassung**

Eine Bedienvorrichtung eines elektronischen Haushaltsgeräts umfasst eine Bedienblende (10) auf der einem Benutzer zugewandten Seite der Bedienvorrichtung, wenigstens ein elektrisch leitfähiges Sensorelement (12) auf der dem Benutzer abgewandten Seite der Bedienblende (10) und eine Leiterplatte (11) mit wenigstens einer elektrisch leitfähigen Kontaktfläche (14), die auf der der Bedienblende (10) zugewandten Seite der Leiterplatte (11) dem wenigstens einen Sensorelement (12) zugeordnet angeordnet ist. Dabei sind das wenigstens eine Sensorelement (12) und die wenigstens eine Kontaktfläche (14) der Leiterplatte (11) über einen zumindest in Verbindungsrichtung elektrisch leitenden Klebstoff (13) miteinander verbunden.

## Beschreibung

Die vorliegende Erfindung betrifft eine Bedienvorrichtung eines elektronischen Haushaltsgeräts sowie ein Verfahren zur Herstellung einer solchen Bedienvorrichtung.

Bedienvorrichtungen für elektronische Haushaltsgeräte werden immer häufiger mit berührungsempfindlichen Tastschaltern ausgestattet, die auf einem optischen, kapazitiven oder induktiven Effekt beruhen. Im Fall von kapazitiven oder induktiven Tastschaltern ist üblicherweise an der dem Benutzer abgewandten Rückseite einer Bedienblende ein entsprechendes, elektrisch leitfähiges Sensorelement angeordnet, welches mit einer zugehörigen Kontaktfläche auf einer hinter der Bedienblende angeordneten Leiterplatte elektrisch leitend verbunden ist. Die Leiterplatte ist Teil einer Steuer- und/oder Auswerteelektronik oder mit einer solchen verbunden.

Die elektrisch leitende Verbindung zwischen dem Sensorelement des Tastschalters und der Kontaktfläche auf der Leiterplatte wird bei derartigen Bedienvorrichtungen herkömmlicherweise über mechanische Komponenten wie beispielsweise metallische Federelemente oder Kontaktteile (vgl. DE 201 19 700 U1) hergestellt. Diese Federelemente bzw. Kontaktteile stützen sich direkt gegen die Kontaktfläche und das Sensorelement ab und werden zum Teil zusätzlich fixiert (z.B. Verklemmen, Verrasten, Verlöten, etc.).

Die so konstruierten Bedienvorrichtungen benötigen somit spezielle mechanische Verbindungselemente aus einem elektrisch leitenden Material, die hergestellt, eingefügt und ggf. zusätzlich fixiert werden müssen. Außerdem kann die Funktionsfähigkeit der Verbindungselemente mit der Betriebsdauer aufgrund von thermischen und mechanischen Belastungen abnehmen; dies gilt insbesondere bei der Verwendung von Federelementen für diese Komponenten.

Die DE 103 26 684 A1 offenbart eine Bedienvorrichtung für ein elektronisches Haushaltsgerät, bei welchem das Sensorelement in Form einer Folie ausgebildet ist, die über den eigentlichen Sensorbereich hinaus verlängert und zur Leiterplatte geführt ist, wo sie mechanisch gehalten und elektrisch kontaktiert wird. Eine relative mechanische Fixierung zwischen der Leiterplatte und dem Sensorelement sowie der Bedienblende kann über ein zwischengesetztes Lichtleitelement erzielt werden.

Ferner beschreibt die DE 10 2008 049 176 A1, welche einen nachveröffentlichten Stand der Technik bildet, eine Bedienvorrichtung für ein elektronisches Haushaltsgerät, auf dem der Oberbegriff des Anspruches 1 basiert. Bei dieser Bedienvorrichtung sind das Sensorelement und die Kontaktfläche der Leiterplatte über einen Leitkleber direkt elektrisch miteinander verbunden. Zur Fixierung der Leiterplatte wird diese zusätzlich über eine Haltevorrichtung mit einer permanenten Andruckkraft gegen das Sensorelement und damit auch gegen den Blendenkörper gedrückt.

Es ist eine Aufgabe der vorliegenden Erfindung, eine Bedienvorrichtung für ein elektronisches Haushaltsgerät zu schaffen, das eine dauerhafte Funktionsfähigkeit gewährleistet und einfach herzustellen ist.

Gemäß einem ersten Aspekt der Erfindung wird diese Aufgabe gelöst durch eine Bedienvorrichtung für ein elektronisches Haushaltsgerät mit den Merkmalen des Anspruches 1. Vorteilhafte Ausgestaltungen und Weiterbildungen der Erfindung sind Gegenstand der abhängigen Ansprüche 2 und 3.

Die Bedienvorrichtung eines elektronischen Haushaltsgeräts weist eine Bedienblende auf der einem Benutzer zugewandten Seite der Bedienvorrichtung; wenigstens ein elektrisch leitfähiges Sensorelement auf der dem Benutzer abgewandten Seite der Bedienblende; und eine Leiterplatte mit wenigstens einer elektrisch leitfähigen Kontaktfläche, die auf der der Bedienblende zugewandten Seite der Leiterplatte dem wenigstens einen Sensorelement zugeordnet angeordnet ist, auf. Die Bedienvorrichtung ist erfindungsgemäß **dadurch gekennzeichnet, dass** das wenigstens eine Sensorelement und die wenigstens eine Kontaktfläche der Leiterplatte über einen zumindest in Verbindungsrichtung elektrisch leitenden Klebstoff direkt elektrisch miteinander verbunden und mechanisch fixiert sind, wobei der Klebstoff im Wesentlichen aus einem unter Druck und/oder Temperatur aushärtenden Material besteht.

Im Gegensatz zu den herkömmlichen Bedienvorrichtungen, bei denen die Sensorelemente der berührungsempfindlichen Tastschalter und die Kontaktflächen der Leiterplatte miteinander über mechanische Komponenten verbunden sind, sind die Sensorelemente und die Kontaktflächen erfindungsgemäß über einen zumindest in Verbindungsrichtung elektrisch leitenden Klebstoff direkt miteinander verbunden und auch fixiert.

Durch diese Maßnahme lassen sich - je nach konkreter Ausgestaltung der Bedienvorrichtung des elektronischen Haushaltsgeräts - ein oder mehrere der folgenden Vorteile erzielen.

Durch die Verwendung des Klebstoffes für die mechanische Fixierung und die elektrisch leitende Verbindung entfällt die Notwendigkeit weiterer zusätzlicher Komponenten. Dies verringert die Anzahl der Bauteile und reduziert damit die Herstellungskosten und den Herstellungsaufwand.

Es entfällt eine zusätzliche mechanische Fixierung eines Verbindungselements. Die mechanische Fixierung und die elektrisch leitende Verbindung werden bei der erfindungsgemäßen Bedienvorrichtung gleichzeitig durch den Klebstoff bewirkt.

Die Verwendung des Klebstoffes erlaubt den Ausgleich von Fertigungs- und Positionierungstoleranzen der Bedienblende und des Sensorelements einerseits und der Leiterplatte und der Kontaktfläche andererseits.

Die Klebstoffverbindung ist in einfacher Weise auch bei gekrümmten Bedienblenden und gekrümmten Leiterplatten anwendbar.

Die Verwendung des Klebstoffes erlaubt eine dauerhaft funktionsfähige, elektrisch leitende Verbindung zwischen den Sensorelementen und den Kontaktflächen.

Die Klebstoffverbindung besitzt häufig eine gewisse Elastizität, weshalb sie bei thermischen und mechanischen Einflüssen noch sicherer dauerhaft ihre Funktionalität beibehalten kann.

Gegenüber dem Löten hat die Klebetechnik zudem den Vorteil, dass die maximal auftretenden Temperaturen niedriger sind, sodass die Gefahr einer Beeinträchtigung oder Zerstörung elektronischer Bauelemente wesentlich geringer ist.

Der zumindest in Verbindungsrichtung elektrisch leitende Klebstoff kann zum Beispiel ein so genannter Leitkleber sein. Dabei können sowohl isotrope Leitkleber als auch anisotrope Leitkleber verwendet werden. Leitkleber bestehen zum Beispiel aus einer Polymermatrix, in der elektrisch leitfähige, metallische oder nichtmetallische Füllstoffe (z.B. Edelmetallpulver wie Silber) enthalten sind.

Die Bedienvorrichtung kann in elektronischen Haushaltsgeräten wie Herden, Kochfeldern, Mikrowellenöfen, Waschmaschinen, Trockner, Spülmaschinen und dergleichen in vorteilhafter Weise zum Einsatz kommen.

Gemäß der Erfindung besteht der Klebstoff im Wesentlichen aus einem unter Druck und/oder Temperatur aushärtenden Material.

In einer Ausgestaltung der Erfindung hat der Klebstoff die Form einer Klebefolie, eines Klebebandes oder einer Klebepaste.

Die Erfindung ist vorteilhafterweise auf eine Bedienvorrichtung anwendbar, bei welcher das wenigstens eine Sensorelement ein kapazitives oder induktives Sensorelement ist und die Leiterplatte mit einer Steuer- und/oder Auswerteelektronik versehen oder verbunden ist.

Gemäß einem zweiten Aspekt der Erfindung wird die oben genannte Aufgabe gelöst durch ein Verfahren zur Herstellung einer Bedienvorrichtung für ein elektronisches Haushaltsgerät mit den Merkmalen des Anspruches 4. Vorteilhafte Ausgestaltungen und Weiterbildungen der Erfindung sind in den abhängigen Ansprüchen 5 und 6 angegeben.

Das Verfahren zur Herstellung einer Bedienvorrichtung eines elektronischen Haushaltsgeräts enthält die Schritte des Bereitstellens einer Bedienblende; des Vorsehens wenigstens eines elektrisch leitfähigen Sensorelements auf der einem Benutzer abgewandten Seite der Bedienblende; und des Bereitstellens einer Leiterplatte mit wenigstens einer elektrisch leitfähigen Kontaktfläche, die auf der der Bedienblende zugewandten Seite der Leiterplatte dem wenigstens einen Sensorelement zugeordnet angeordnet ist. Erfindungsgemäß weist das Verfahren zudem einen Schritt des direkten elektrischen Verbindens und mechanischen Fixierens des wenigstens einen Sensorelements mit der wenigstens einen Kontaktfläche der Leiterplatte durch Applizieren eines zumindest in Verbindungsrichtung elektrisch leitenden Klebstoffes im Bereich zwischen dem wenigstens einen Sensorelement und der wenigstens einen Kontaktfläche und Aushärten des Klebstoffes unter Druck und/oder Temperatur auf.

Die mit diesem Verfahren erzielbaren Vorteile entsprechen den oben in Zusammenhang mit der erfindungsgemäßen Bedienvorrichtung genannten Vorteilen.

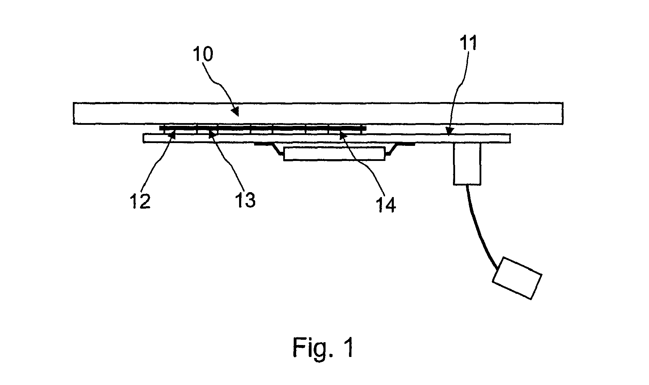

Obige sowie weitere Merkmale, Vorteile und Anwendungsmöglichkeiten der Erfindung werden aus der nachfolgenden Beschreibung eines bevorzugten, nichteinschränkenden Ausführungsbeispiels unter Bezugnahme auf die beiliegende Zeichnung besser verständlich. Darin zeigt die einzige Figur 1 eine schematische Darstellung des Aufbaus einer Bedienvorrichtung eines elektronischen Haushaltsgeräts gemäß der vorliegenden Erfindung.

Die Bedienvorrichtung umfasst eine Bedienblende 10 eines elektronischen Haushaltsgeräts. In Fig. 1 ist eine Bedienvorrichtung mit einer planen Bedienblende 10 veranschaulicht, es können aber ebenso gekrümmte Bedienblenden 10 benutzt werden. Ferner kann die Bedienblende 10 eine Blende aus einem transparenten, einem teildurchlässigen oder einem lichtundurchlässigen Material sein.

In der Bedienvorrichtung sind mehrere berührungsempfindliche Tastschalter integriert, die kapazitive oder induktive Sensoren aufweisen. Diese Sensoren weisen üblicherweise jeweils wenigstens ein elektrisch leitfähiges Sensorelement 12 auf der dem Benutzer abgewandten Rückseite der Bedienblende 10 (unten in Fig. 1) auf.

Diese Sensorelemente 12 stehen mit elektrisch leitfähigen Kontaktflächen 14 auf einer Leiterplatte 11 in Kontakt, die auf der dem Benutzer abgewandten Seite hinter der Bedienblende 10 angeordnet ist. Die Leiterplatte 11 ist mit einer Steuer- und/oder Auswerteelektronik zum Beispiel in Form einer Konvertierungselektronik oder dergleichen versehen oder mit einer solchen verbunden. Ebenso kann die Leiterplatte 11 als Bestandteil der Steuer- und Auswerteelektronik angesehen werden.

Die elektrisch leitende Verbindung und die mechanische Fixierung zwischen dem wenigstens einen Sensorelement 12 und der wenigstens einen Kontaktfläche 14 der Leiterplatte 11 erfolgt über einen zumindest in Verbindungsrichtung (Oben/Unten-Richtung in Fig. 1) elektrisch leitenden Klebstoff 13. Der Klebstoff 13 muss zumindest in Verbindungsrichtung, d.h. in der Dickenrichtung der Folie oder des Bandes elektrisch leitend sein, und kann insbesondere auch in allen Richtungen elektrisch leitend ausgebildet sein.

Bei diesem Klebstoff 13 handelt es sich zum Beispiel um einen isotropen oder anistropen Leitkleber, der in der Form einer Klebstofffolie, eines Klebstoffbandes oder einer Klebstoffpaste vorliegt. Typischerweise handelt es sich bei dem Leitkleber um eine Polymermatrix, die elektrisch leitfähige, metallische oder nichtmetallische Füllstoffe enthält. Bei den Füllstoffen kann es sich zum Beispiel um ein Edelmetallpulver, beispielsweise um Silberpartikel handeln.

Der Klebstoff 13 wird zunächst im Bereich zwischen dem Sensorelement 12 und der Kontaktfläche 14 appliziert. Zur dauerhaften Verbindung wird der Klebstoff dann unter einem vorbestimmten Druck und/oder einer vorbestimmten Temperatur für eine vorbestimmte Zeitdauer ausgehärtet. Hierdurch wird erreicht, dass die elektrische und mechanische Verbindung zwischen Sensorelement 12 und Kontaktfläche 14 trotz nachfolgender thermischer und mechanischer Einflüsse dauerhaft funktionsfähig bleibt.

Durch den Klebstoff 13 können zusätzliche mechanische Fixierungen eines mechanischen Verbindungselements und weitere Prozessschritte vermieden und Fertigungstoleranzen der Bauteile und Positionsungenauigkeiten bei der Montage ausgeglichen sowie ggf. gekrümmte Flächen miteinander verbunden werden.

## Patentansprüche

1. Bedienvorrichtung eines elektronischen Haushaltsgeräts, mit einer Bedienblende (10) auf der einem Benutzer zugewandten Seite der Bedienvorrichtung; wenigstens einem elektrisch leitfähigen Sensorelement (12) auf der dem Benutzer abgewandten Seite der Bedienblende (10); und einer Leiterplatte (11) mit wenigstens einer elektrisch leitfähigen Kontaktfläche (14), die auf der der Bedienblende (10) zugewandten Seite der Leiterplatte (11) dem wenigstens einen Sensorelement (12) zugeordnet angeordnet ist, wobei das wenigstens eine Sensorelement (12) und die wenigstens eine Kontaktfläche (14) der Leiterplatte (11) über einen zumindest in Verbindungsrichtung elektrisch leitenden Klebstoff (13) direkt elektrisch miteinander verbunden sind,
**dadurch gekennzeichnet, dass**
das wenigstens eine Sensorelement (12) und die wenigstens eine Kontaktfläche (14) der Leiterplatte (11) über den Klebstoff (13) auch mechanisch fixiert sind; und
der Klebstoff (13) im Wesentlichen aus einem unter Druck und/oder Temperatur aushärtenden Material besteht.

2. Bedienvorrichtung nach Anspruch 1,
**dadurch gekennzeichnet, dass**
der Klebstoff (13) die Form einer Klebefolie, eines Klebebandes oder einer Klebepaste hat.

3. Bedienvorrichtung nach Anspruch 1 oder 2,
**dadurch gekennzeichnet, dass**
das wenigstens eine Sensorelement (12) ein kapazitives oder induktives Sensorelement ist und die Leiterplatte (11) mit einer Steuer- und/oder Auswerteelektronik versehen oder verbunden ist.

4. Verfahren zur Herstellung einer Bedienvorrichtung eines elektronischen Haushaltsgeräts, mit den Schritten:
Bereitstellen einer Bedienblende (10);
Vorsehen wenigstens eines elektrisch leitfähigen Sensorelements (12) auf der einem Benutzer abgewandten Seite der Bedienblende (10);
Bereitstellen einer Leiterplatte (11) mit wenigstens einer elektrisch leitfähigen Kontaktfläche (14), die auf der der Bedienblende (10) zugewandten Seite der Leiterplatte (11) dem wenigstens einen Sensorelement (12) zugeordnet angeordnet ist; und
direktes elektrisches Verbinden und mechanisches Fixieren des wenigstens einen Sensorelements (12) mit der wenigstens einen Kontaktfläche (14) der Leiterplatte (11) durch Applizieren eines zumindest in Verbindungsrichtung elektrisch leitenden Klebstoffes (13) im Bereich zwischen dem wenigstens einen Sensorelement und der wenigstens einen Kontaktfläche und Aushärten des Klebstoffes unter Druck und/oder Temperatur.

5. Verfahren nach Anspruch 4,
**dadurch gekennzeichnet, dass**
der Klebstoff (13) in Form einer Klebefolie, eines Klebebandes oder einer Klebepaste vorgehalten wird.

6. Verfahren nach Anspruch 4 oder 5,
**dadurch gekennzeichnet, dass**
das wenigstens eine Sensorelement (12) ein kapazitives oder induktives Sensorelement ist und die Leiterplatte (11) mit einer Steuer- und/oder Auswerteelektronik versehen oder verbunden ist.
